# NOUVEAU FASCICULE DE BREVET EUROPEEN

(11) **EP 0 564 335 B2**
(45) Date de publication et mention de la décision concernant l'opposition: **06.12.2000**
(45) Mention de la délivrance du brevet: 09.07.1997
(21) Numéro de dépôt: 93400787.3
(22) Date de dépôt: 26.03.1993
(51) Int. Cl.: H01R 43/20, B29C 51/00

(54) **Procédé d'assemblage d'un connecteur présentant des éléments de contacts coudés**
Verfahren zum Zusammenbauen eines Winkelkontaktelemente aufweisenden Verbinders
Process for assembling a connector provided with bent contact elements

(30) Priorité: 03.04.1992 FR 9204066
(43) Date de publication de la demande: 06.10.1993
(73) Titulaire: FRAMATOME CONNECTORS INTERNATIONAL, 92084 Paris La Défense (FR)
(72) Inventeur: Pesson, Michel, F-72460 Sille le Philippe (FR); Fonteneau, Michel, F-72000 Le Mans (FR)
(74) Mandataire: Beetz jr., Richard, Dr.-Ing.

(56) Documents cités:
- WO-A-88/07776
- DE-A- 2 833 153
- JP-A- 2 046 675
- US-A- 4 898 215
- US-A- 5 046 243
- US-A- 5 101 318

## Description

La présente invention a pour objet un procédé d'assemblage d'un connecteur présentant des éléments de contacts coudés en partie arrière en vue de leur montage dans un circuit imprimé.

Il est connu de la demande de brevet PCT WO-88/7776 d'assembler un tel connecteur en disposant l'extrémité distale de la partie arrière de tels éléments coudés, dans des fentes présentant un profil permettant de bloquer mécaniquement lesdites extrémités distales dans les fentes respectives.

La fabrication d'un tel connecteur est difficile en raison de la forme compliquée du profil des fentes nécessaire à obtenir une telle immobilisation. En outre, le montage ne peut se faire qu'avec des contacts coudés au préalable.

On connaît par ailleurs un procédé d'assemblage d'un connecteur présentant des éléments de contact coudés en rapportant dans le corps isolant une grille présentant des ouvertures pour immobiliser les extrémités distales des éléments de contact. Ce procédé a pour inconvénient d'exiger une pièce supplémentaire qui doit être encliquetée dans le corps isolant et qui apporte un jeu supplémentaire de montage qui détériore la précision de positionnement des éléments de contact.

La présente invention a pour objet un procédé d'assemblage qui ne présente pas les inconvénients précités.

L'invention concerne ainsi un procédé d'assemblage d'un connecteur présentant un corps isolant comportant une partie avant dans laquelle est insérée une partie active d'une pluralité d'éléments de contact, lesdits éléments de contact présentant également une partie arrière coudée ayant une extrémité distale disposée dans une fente correspondante d'une aile arrière du corps isolant, caractérisé en ce qu'il comporte une étape d'immobilisation par thermoformage des extrémités distales d'au moins certains desdits contacts dans leurs fentes respectives sans apport de matière.

On remarquera que la mise en oeuvre d'une aile arrière en forme de peigne et du procédé de thermoformage permet d'immobiliser plusieurs rangées de contact quelle que soit leur configuration tout en gardant une géométrie simple des fentes, en particulier pour des connecteurs à trois rangées avec disposition en ligne des branches distales.

Selon un mode de réalisation préféré, l'étape de thermoformage est réalisée à l'aide de broches creuses portées à une température de thermoformage de la matière constituant le corps isolant et introduites par l'extrémité distale des éléments de contact jusqu'à venir en appui par une extrémité avant sur des bords desdites fentes. Les broches creuses assurent ainsi un positionnement relativement précis de l'extrémité distale des éléments de contact lors du thermoformage. L'extrémité avant des broches creuses peut être sensiblement conique, ce qui permet de faciliter l'introduction des contacts et leur repositionnement.

Le procédé peut comporter une mise en oeuvre d'une pièce de maintien pour maintenir en place l'aile arrière lors de l'opération de thermoformage, ce qui permet d'éviter tout déplacement des fentes et d'obtenir un positionnement précis lors de l'opération de thermoformage.

Ce procédé est tout à fait compatible avec la mise en oeuvre d'une étape de cambrage in situ pour couder les parties arrières des éléments de contact préalablement à l'étape de thermoformage.

L'invention concerne également un connecteur présentant un corps isolant comportant une partie avant dans laquelle est insérée une partie active d'une pluralité d'éléments de contact, lesdits éléments de contact présentant également une partie arrière coudée ayant une extrémité distale disposée dans une fente correspondante d'une aile arrière du corps isolant caractérisée en ce que l'extrémité distale d'au moins certains éléments de contact est immobilisée dans la fente correspondante par un repli de matière solidaire des bords de ladite fente, lequel repli étant formé par thermoformage sans apport de matière.

La structure est particulièrement avantageuse en ce sens qu'elle procure un positionnement précis des extrémités distales de la partie arrière des éléments de contact sans nécessiter de pièces rapportées ni de forme de découpe ou de moulage compliquée pour les fentes.

Les replis de matière entourent avantageusement une majeure partie de ladite extrémité distale et sont de préférence constitués par une empreinte de thermoformage.

D'autres caractéristiques et avantages de l'invention apparaîtront à la lecture de la description qui va suivre donnée à titre d'exemple non limitatif en liaison avec les dessins qui représentent :
- les figures 1a et 1b, deux vues en perspective d'un connecteur à sortie arrière coudée tel que fabriqué actuellement par la demanderesse, la figure la comportant en outre deux vues de détail en encadré ;
- les figures 2a et 2b, deux vues en perspective d'un connecteur selon un mode préféré de réalisation de l'invention, la figure 2a comportant une vue de détail en encadré illustrant les empreintes de thermoformage ;
- les figures 3a et 3b, respectivement, en coupe transversale, un connecteur selon l'invention au cours d'une étape de thermoformage, et une coupe longitudinale partielle d'une broche selon l'invention.

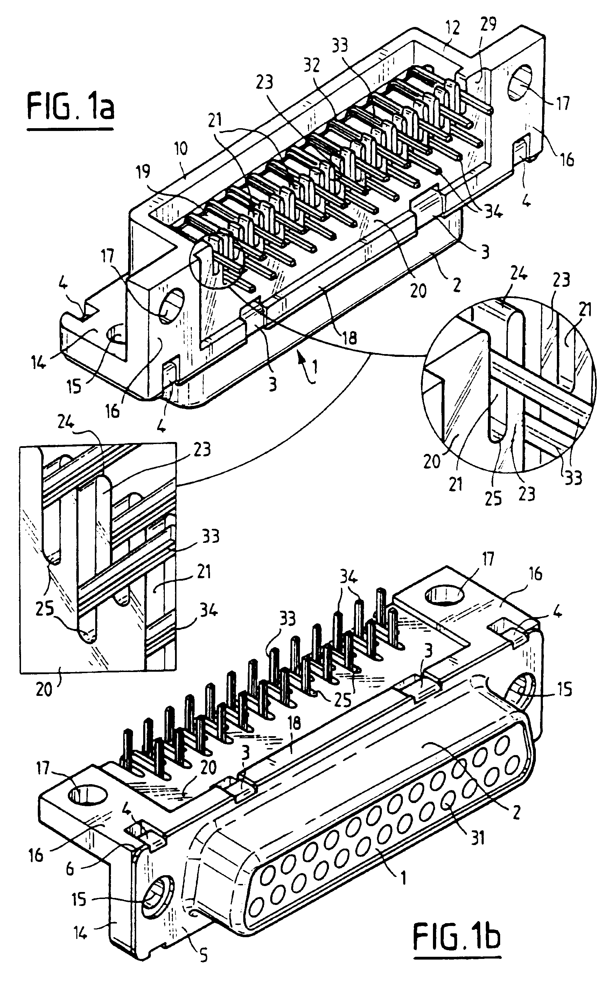

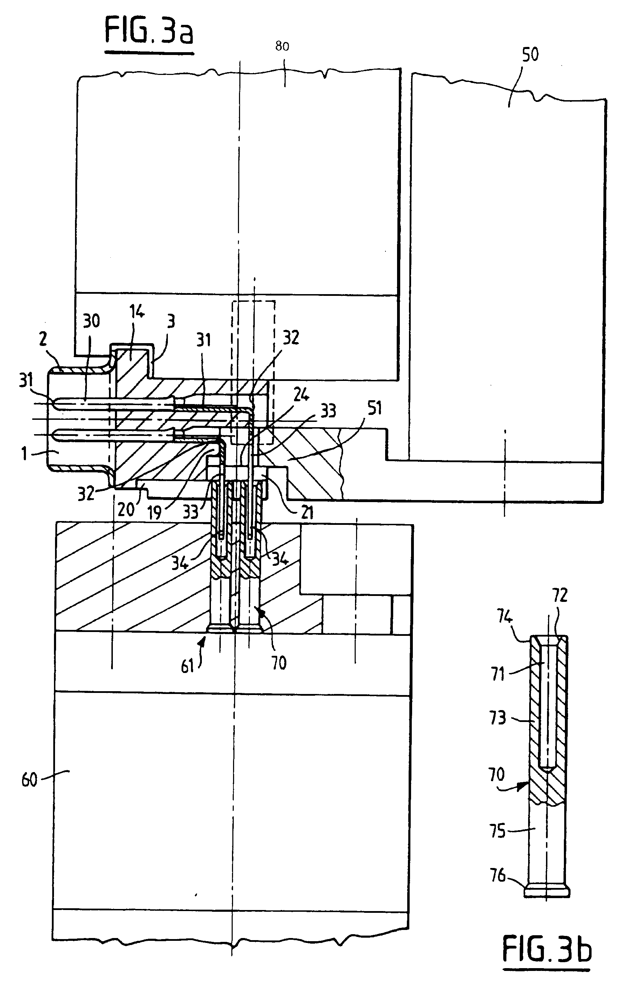

Selon les figures 1a et 1b, un connecteur de l'art antérieur fabriqué par la demandresse comporte un corps isolant présentant une partie avant surélevée 1 par rapport à une face plane avant 6, d'une plaque d'appui rectangulaire 14. Perpendiculairement à la plaque d'appui 14, s'étendent une aile présentant une partie centrale 20 et deux parties latérales 16. La région centrale 20 est légèrement en retrait vers l'avant en formant un dégagement parallélépipédique 29. Les trous lisses de montage 15 et 17 sont ménagés respectivement à la plaque rectangulaire 14 et dans les ailes 16 aux extrémités longitudinales des connecteurs. Un boîtier conducteur de blindage présentant une portion 2 s'adaptant à la partie surélevée 1 et une région plane 5 venant en butée sur la face avant 6 est maintenu en place par des pattes de fixation repliées 3 et 4 respectivement sur un rebord 18 jouxtant le dégagement 29 et dans les ailes 16. Des éléments de contact (voir fig. 3a) présentant une partie avant active 30 du type "mâle" située en retrait de l'ouverture correspondante 31 de l'isolant avant 1 se prolongent vers l'arrière du connecteur par une partie arrière présentant une première section droite 31 dans le prolongement de la partie active avant 30, un coude 32, et une partie distale 33 se terminant par une extrémité 34 insérable dans des trous d'un circuit imprimé par exemple.

On a représenté deux rangées d'éléments de contact disposées en quinconce, chaque élément de contact étant disposé dans une fente 21, les fentes étant séparées les unes des autres par des bords 23 se terminant par des parties distales arrondies 24. Les coudes 32 des éléments de contact sont repliés autour de rebords 19 qui font partie intégrante du corps isolant et viennent de moulage avec celui-ci. Le corps isolant présente enfin une partie de boîtier en forme de U entourant les éléments de contact et présentant une partie rectangulaire longitudinale 10 et deux faces latérales 11 et 12 s'appuyant sur la plaque avant 14. Les faces latérales 11 et 12 se raccordent aux ailes 16 du corps isolant et forment un trièdre avec les extrémités de la plaque d'appui 14 et les ailes 16.

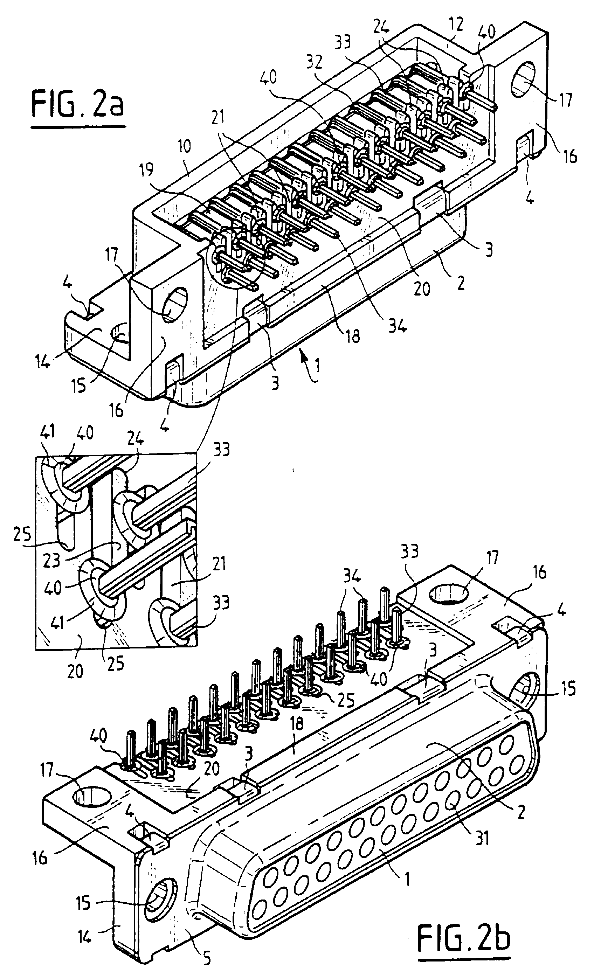

Selon les figures 2a et 2b, une immobilisation des éléments de contact dans les fentes 21 est obtenue grâce à des empreintes entourant les parties distales 33, de préférence sur la totalité de leur pourtour, qui sont solidaires des bords 23 des fentes 21 qu'elles interrompent sur une partie de leur pourtour.

Selon les figures 3a et 3b, ces empreintes sont réalisées à l'aide de broches creuses 70 présentant un corps central cylindrique 75 se prolongeant vers l'arrière par une collerette 76 de maintien dans une pièce 60, un trou borgne 71 débouchant sur la partie avant de la broche 70 pour définir une partie avant 74 présentant une portion interne 72 évasée coniquement vers l'extérieur. Cette forme de la broche définit la forme des empreintes telles que représentées en encadré de la figure 2a.

Pour réaliser l'opération de thermoformage, un nombre de broches 70 correspondant au nombre des éléments de contact 30 à maintenir en position est inséré dans des ouvertures débouchantes de la partie avant 61 d'une pièce de montage de thermoformage 60. L'extrémité distale 33 des parties arrière des éléments de contact 30 est insérée dans les trous borgnes 71 des broches creuses 70 par leur extrémité 34 et la pièce 60 est déplacée jusqu'à venir en butée sur les bords 23 formant séparation entre les fentes 21 et sont appliquées à force dans celles-ci pour réaliser l'empreinte de thermoformage 40 par fusion de la matière, les broches 70 ayant été préalablement portées à une température de thermoformage du matériau constituant le corps isolant du connecteur. La portion 72 évasée coniquement fait office de chanfrein d'introduction des extrémités distales (33, 34) qui sont maintenues en position avec la précision souhaitable dans les trous borgnes 71.

Pour réaliser l'opération, la plaque avant 14 est immobilisée par son bord supérieur grâce à une pièce 80 coopérant avec une pièce 50 présentant une extrémité avant 51 qui vient d'une part former butée par l'avant sur les extrémités 24 des bords 23 et d'autre part, maintenir en place la partie arrière du corps isolant. Le procédé est de préférence automatisé par un système d'amenée des connecteurs successifs dans une chaîne de fabrication où l'opération de thermoformage est de ce fait entièrement automatique.

## Revendications

1. Procédé d'assemblage d'un connecteur présentant un corps isolant comportant une partie avant (1) dans laquelle est insérée une partie active (30) d'une pluralité d'éléments de contact, lesdits éléments de contact présentant chacun également une partie arrière coudée (32) ayant une extrémité distale (33) disposée dans une fente (21) correspondante d'une aile arrière du corps isolant, fente longitudinale et ouverte à l'une de ses extrémités,
caractérisé en ce
qu'il comporte une étape d'immobilisation des extrémités distales (33) d'au moins certains desdits éléments de contact dans leurs fentes respectives (21) par thermoformage sans apport de matière des régions des bords de fentes entourant l'élément de contact jusqu'à ce que ceux-ci entourent entièrement l'élément de contact.

2. Procédé selon la revendication 1, caractérisé en ce que l'étape de thermoformage est réalisée à l'aide de broches creuses (70) portées à une température de thermoformage de la matière constituant le corps isolant (1, 20) et introduites par l'extrémité distale des éléments de contact jusqu'à venir en appui par une extrémité avant (74) sur des bords (23) desdites fentes (21).

3. Procédé selon la revendication 2, caractérisé en ce que l'extrémité avant (74) des broches creuses (70) est sensiblement conique.

4. Procédé selon la revendication 2, caractérisé en ce qu'il comporte la mise en oeuvre d'une pièce de maintien (61) pour maintenir en place l'aile arrière (20) lors de l'opération du thermoformage.

5. Procédé selon une des revendications précédentes, caractérisé en ce qu'il comporte une étape de cambrage in situ pour couder les parties arrière (33) des éléments de contact (30, 34) préalablement à l'étape de thermoformage.

6. Connecteur présentant un corps isolant comportant une partie avant dans laquelle est usinée une partie active d'une pluralité d'éléments de contact, lesdits éléments de contact présentant chacun également une partie arrière coudée ayant une extrémité distale disposée dans une fente correspondante d'une aile arrière du corps isolant, fente longitudinale et ouverte à l'une de ses extrémités,
caractérisé en ce que
l'extrémité distale d'au moins certains éléments de contact (30, 34) est immobilisée dans la fente (21) correspondante par un repli (40) de matière solidaire des bords (23) de ladite fente (21), ce repli (40) entourant entièrement l'élément de contact et étant formé par thermoformage sans apport de matière.

7. Connecteur selon la revendication 6, caractérisé en ce que ledit repli (40) de matière entoure une majeure partie de ladite extrémité distale (33).

## Claims

1. Method for assembling a connector having an insulator body comprising a front part (1) into which is inserted an active part (30) of a plurality of contact elements, said contact elements each also having a bent rear part (32) which has a distal end (33) located in a corresponding slot (21) of a rear flange of the insulator body, said slot being longitudinal and open at one of its ends,
characterized in that
the distal ends are bent around a shoulder (19) of the insulator body and that it includes a step of immobilizing the distal ends (33) of at least some of said contact elements in their respective slots (21) by thermoforming without material feed the regions of the slot edges surrounding the contact element until they completely surround the contact element.

2. Method according to claim 1, characterized in that the thermoforming step is carried out by means of hollow pins (70) which are brought to a temperature for thermoforming the material making up the insulator body (1, 20) and are inserted via the distal end of the contact elements until they come to bear via a front end (74) on edges (23) of said slots (21).

3. Method according to claim 2, characterized in that the front end (74) of the hollow pins (70) is substantially conical.

4. Method according to claim 2, characterized in that it includes the use of a holding piece (61) for holding the rear flange (20) in place during the thermoforming operation.

5. Method according to one of the preceding claims, characterized in that it includes an in situ bending step for bending the rear parts (33) of the contact elements (30, 34) prior to the thermoforming step.

6. Connector having an insulator body comprising a front part in which an active part of a plurality of contact elements is machined, said contact elements each also having a bent rear part which has a distal end located in a corresponding slot of a rear flange of the insulator body, said slot being longitudinal and open at one of its ends,
characterized in that
the distal end of at least some contact elements (30, 34) is immobilized in the corresponding slot (21) by a fold (40) of a material integral with the edges (23) of said slot (21), this fold (40) completely surrounding the contact element and being shaped by a thermoforming operation without material feed realized by a method according to one of claims 1 to 5.

7. Connector according to claim 6, characterized in that said fold is a thermoforming impression (40, 41).

## Patentansprüche

1. Verfahren zum Zusammenbau eines Verbinders, der einen Isolierkörper mit einem vorderen Bereich (1) aufweist, in den ein aktiver Bereich (30) mehrerer Kontaktelemente eingeführt wird, wobei die Kontaktelemente außerdem je einen abgewinkelten hinteren Bereich (32) mit einem in einem entsprechenden Schlitz (21) eines hinteren Flügels des Isolierkörpers angeordneten, fernen Ende (33) aufweisen, wobei der Schlitz länglich und an einem seiner Enden offen ist,
dadurch gekennzeichnet, daß
die fernen Enden um eine Randleiste (19) des Isolierkörpers umgebogen sind, und daß es einen Schritt der Blockierung der fernen Enden (33) mindestens einiger der Kontaktelemente in ihren jeweiligen Schlitzen (21) durch Thermoformung ohne Materialzufuhr der Bereiche der das Kontaktelement umgebenden Schlitzränder, bis diese das Kontaktelement vollständig umgeben, aufweist.

2. Verfahren nach Anspruch 1, dadurch gekennzeichnet, daß der Thermoformungsschritt mit Hilfe hohler Stifte (70) durchgeführt wird, die auf eine Temperatur zur Thermoformung des den Isolierkörper (1, 20) bildenden Materials gebracht und über das ferne Ende der Kontaktelemente eingeführt werden, bis sie mit einem vorderen Ende (74) auf Rändern (23) der Schlitze (21) aufliegen.

3. Verfahren nach Anspruch 2, dadurch gekennzeichnet, daß das vordere Ende (74) der hohlen Stifte (70) im wesentlichen kegelförmig ist.

4. Verfahren nach Anspruch 2, dadurch gekennzeichnet, daß es die Anwendung eines Halteteils (61) umfaßt, um den hinteren Flügel (20) während des Thermoformungsvorgangs an Ort und Stelle zu halten.

5. Verfahren nach einem der vorhergehenden Ansprüche, dadurch gekennzeichnet, daß es einen Schritt des Durchbiegens vor Ort aufweist, um die hinteren Bereiche (33) der Kontaktelemente (30, 34) vor dem Thermoformungsschritt anzuwinkeln.

6. Verbinder, der einen Isolierkörper mit einen vorderen Bereich aufweist, in den ein aktiver Bereich mehrerer Kontaktelemente eingearbeitet ist, wobei die Kontaktelemente außerdem je einen abgewinkelten hinteren Bereich mit einem in einem entsprechenden Schlitz eines hinteren Flügels des Isolierkörpers angeordneten, fernen Ende aufweisen, wobei der Schlitz länglich und an einem seiner Enden offen ist,
dadurch gekennzeichnet, daß
das ferne Ende mindestens einiger Kontaktelemente (30, 34) im entsprechenden Schlitz (21) durch einen Falz (40) aus mit den Rändern (23) des Schlitzes (21) fest verbundenem Material blockiert wird, wobei dieser Falz (40) das Kontaktelement vollständig umgibt und durch eine Thermoformung ohne Materialzufuhr gebildet wird, die durch ein Verfahren gemäß einem der Ansprüche 1 bis 5 durchgeführt wird.

7. Verbinder nach Anspruch 6, dadurch gekennzeichnet, daß dieser Materialfalz eine Thermoformungsprägung (40, 41) ist.
